# EUROPÄISCHE PATENTANMELDUNG

(11) **EP 0 969 600 A1**
(43) Veröffentlichungstag der Anmeldung: **05.01.2000**
(21) Anmeldenummer: 99112559.2
(22) Anmeldetag: 01.07.1999
(51) Int. Cl.: H03K 17/945

(54) **Näherungsschalter mit integrierter Funktionsprüfung**

(30) Priorität: 03.07.1998 DE 19829852
(71) Anmelder: SIEMENS AKTIENGESELLSCHAFT, 80333 München (DE)
(72) Erfinder: Schwarz, Robert, Dipl.-Ing., 92272 Freudenberg (DE)

(57) **Zusammenfassung**

Erfindungsgemäß wird der Mikroprozessor (4) in einem Näherungsschalter (1) zur Erzeugung eines Rechtecksignals herangezogen, das über ein Netzwerk (18, 19, 20) am Eingang (9) einer Weiterverarbeitungseinheit (3) eingekoppelt wird, um deren Funktionsprüfung zu realisieren.

Weiterhin wird ein erfindungsgemäßes Verfahren zur Funktionsprüfung eines Näherungsschalters (1) angegeben, das die Generierung eines Rechtecksignals im Mikroprozessor (4) sowie die Weiterleitung und Einkopplung eines Prüfsignals umfaßt.

## Beschreibung

Die Erfindung bezieht sich auf einen Näherungsschalter mit einem Sensor, mit einer diesem über einen Eingang nachgeschalteten Weiterverarbeitungseinheit, die zur Verarbeitung eines am Ausgang des Sensors anstehenden Signals dient, und mit einem Mikroprozessor zur Auswertung eines am Ausgang der Weiterverarbeitungseinheit anstehenden Digitalsignals.

Weiterhin bezieht sich die Erfindung auf ein Verfahren zur Funktionsüberprüfung eines Näherungsschalters.

Ein gattungsgemäßer Näherungsschalter, z.B. ein Ultraschall-Näherungsschalter, ist bekannt. Üblicherweise enthalten diese Näherungsschalter Verstärker-, Steuerungs- und Regelungskomponenten. Zur Sicherstellung der Gerätefunktion ist die Überprüfung der Verstärkerkennwerte sowie der Regel- und Steuerungszeitkonstanten unumgänglich. Bisher war es zur Funktionsüberprüfung erforderlich, durch aufwendige Kontaktierung eines externen Funktionsgenerators unterschiedliche sinusförmige Analog-Signale mit sehr kleinen Amplitudenwerten auf den Verstärkereingang einzuspeisen. Durch Messungen am Verstärkerausgang und an den Regel- und Steuerungsanschlüssen wurden die einzelnen Funktionen überprüft. Dabei ist eine Einspeisung von Analog-Signalen mit geringer Amplitude erforderlich, um eine Mindestempfindlichkeit des Verstärkers sicherzustellen. Dies ist häufig in Folge von Störeinkopplungen durch Masseschleifen, Rauschsignalen usw. mit Problemen verbunden.

Außerdem lassen sich diese Prüfungen wegen der erforderlichen Kontaktierung nur an der offenen Elektronik vornehmen, d.h. diese Überprüfungen sind nur bis zu einem relativ frühen Fertigungsstand, z.B. vor dem Verguß oder dem Gehäuseeinbau möglich. Eine entsprechende Prüfung des Fertiggerätes zu einem späteren Zeitpunkt, z.B. zur Geräteüberprüfung bei einer Anwendung, war nicht durchführbar.

Daher liegt der Erfindung die Aufgabe zugrunde, einen Näherungsschalter der obengenannten Art zu schaffen, der auch eine Funktionsüberprüfung im Fertigzustand ermöglicht.

Eine weitere Aufgabe der Erfindung besteht darin, ein Verfahren zur Funktionsüberprüfung anzugeben, mit dem Komponenten des Näherungsschalters auch im Fertigzustand mit geringem Aufwand überprüfbar sind.

Die zuerst angeführte Aufgabe wird dadurch gelöst, daß der Mikroprozessor einen Ausgang aufweist, der über ein Netzwerk mit dem Eingang gekoppelt ist, wobei das Netzwerk zur Anpassung und Einkopplung eines im Mikroprozessor generierten Rechtecksignals am Eingang dient. Bei dieser Lösung wird der bereits vorhandene Mikroprozessor mit seiner zusätzlichen Funktionalität ausgenutzt, wobei mit geringem zusätzlichen Hardwareaufwand die Einkopplung eines Prüfsignals am Verstärkereingang ermöglicht wird.

Vorteilhafterweise weist das Netzwerk einen ohmschen Teiler auf, der einen hochohmigen und einen niederohmigen Widerstand enthält.

Um das im Normalbetriebsmodus am Verstärkereingang anstehende Analogsignal zu simulieren, wird vorteilhafterweise die Frequenz des Rechtecksignals aus einem oder mehreren Taktzyklen eines im Mikroprozessor eingebauten Timers gebildet.

Das erfindungsgemäße Verfahren gemäß der weiteren obengenannten Aufgabenstellung hilft ein Verfahren zur Funktionsprüfung eines Näherungsschalters, der einen Sensor, eine Weiterverarbeitungseinheit und einen Mikroprozessor aufweist, wobei die Weiterverarbeitungseinheit zur Verarbeitung eines im Normalbetriebsmodus vom Sensor empfangenen Analogsignals und anschließenden Weiterleitung an den Mikroprozessor zur dortigen Auswertung dient. Das Verfahren ist dadurch gekennzeichnet, daß der Mikroprozessor ein Rechtecksignal erzeugt, das einem Netzwerk zugeführt und von diesem als Prüfsignal am Eingang der Weiterverarbeitungseinheit zu deren Funktionsüberprüfung eingekoppelt wird.

Eine besonders vorteilhafte Ausgestaltung des Verfahrens besteht daran, daß die Frequenz des Prüfsignals der Frequenz des vom Sensor im Normalbetriebsmodus an die Weiterverarbeitungseinheit gelieferten Analogsignals entspricht.

Eine vorteilhafte Weiterbildung des Verfahrens besteht außerdem, wenn die Einkopplung des Prüfsignals am Eingang der Weiterverarbeitungseinheit über einen Spannungsteiler mit einem hochohmigen Widerstand und einem niederohmigen Widerstand erfolgt, wobei der hochohmige Widerstand zur Amplitudenanpassung des Prüfsignals dient und der niederohmige Widerstand eine serielle Einspeisung am Eingang bewirkt die beim Normalbetrieb keinen störenden Einfluß hat.

Die Erfindung wird im folgenden anhand einer Zeichnung näher erläutert.

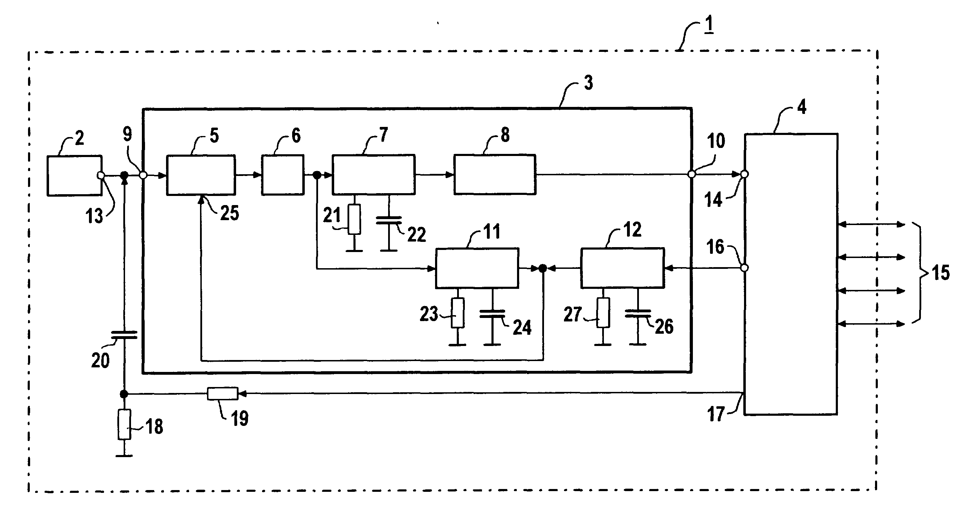

Die Figur zeigt einen Näherungsschalter 1, der im wesentlichen aus einem Sensor 2, einer Weiterverarbeitungseinheit 3 und einem Mikroprozessor 4 aufgebaut ist. Der Sensor 2 kann z.B. ein Ultraschallsensor, ein induktiver oder optischer Sensor sein. Die Weiterverarbeitungseinheit 3 weist hier einen aus einem Verstärker 5, einem Filter 6, einem Demodulator 7 und einem Komparator 8 aufgebauten Zweig auf, wobei die Komponenten in der genannten Reihenfolge in Serie geschaltet sind und am Eingang 9 der Weiterverarbeitungseinheit 3 der Verstärker 5 und am Ausgang 10 derselben der Komparator 8 liegt. Über eine Regelschleife bestehend aus einem Regelverstärker 11 und einer Verstärkungssteuerung 12 erfolgt eine Rückkopplung zum Verstärker 5. Der Ausgang 13 des Sensors 2 ist mit dem Eingang 9 der Weiterverarbeitungseinheit 3 verbunden. Der Ausgang 10 der Weiterverarbeitungseinheit 3 liegt an einem Eingang 14 des Mikroprozessors 4, der eine Parametrierschnittstelle 15 aufweist. Ein Ausgang 16 des Mikroprozessors 4 ist mit der Verstärkungssteuerung 12 verbunden.

Im folgenden wird die Wirkungsweise des soweit bekannten Näherungsschalters erläutert. Bei Detektion durch den Näherungsschalter 1 stehen am Ausgang 13 des Sensors 2 üblicherweise sinusförmige Analogsignale an, die an den Eingang 9 der Weiterverarbeitungseinheit 3 weitergeleitet werden. Nach Verstärkung des Analogsignals im Verstärker 5 gelangt das Signal zum Filter 6, das als Bandfilter zur Ausblendung von Störsignalen ausgelegt ist. Das gefilterte Signal wird anschließend im Demodulator 7 gleichgerichtet und geglättet und in ein niederfrequentes Hüllkurvensignal gewandelt, das im anschließenden Komparator 8 in ein Digitalsignal gewandelt wird. Dieses wird dem Mikroprozessor 4 zur Auswertung zugeführt. Über die Parametrierschnittstelle 15 des Mikroprozessors 4 wird ermöglicht, Daten in den Mikroprozessor 4 ein- und auszulesen.

Erfindungsgemäß ist der soweit beschriebene Näherungsschalter 1 über seinen Ausgang 17, an dem ein Netzwerk angeschlossen ist, mit dem Eingang 9 der Weiterverarbeitungseinheit 3 verbunden. Das Netzwerk besteht aus einem Spannungsteiler aus einem an Masse angebundenen niederohmigen Widerstand 18 und einem hierzu in Reihe liegenden hochohmigen Widerstand 19 sowie einem Kondensator 20, der einerseits an den Verbindungspunkt der beiden Widerständen 18, 19 und andererseits an den Eingang 9 geschaltet ist.

Im Mikroprozessor 4 wird ein in geeigneter Weise zeitlich getaktetes Rechtecksignal am Ausgang 17 generiert, das nach Spannungsteilung durch die Widerstände 18, 19 über den Kondensator 20 am Eingang 9 der Weiterverarbeitungseinheit 3 eingespeist wird. An diesem Eingang 9 liegt gleichzeitig auch das Analogsignal des Sensors 2 an. Nach dem Verstärker gelangen die Signale in das Filter 6, an dessen Ausgang sowohl der Demodulator 7 mit seiner Beschaltung, bestehend aus einem ohmschen Widerstand 21 und einem Kondensator 22, als auch der Regelverstärker 11 mit der Beschaltung durch einen Widerstand 23 und einen Kondensator 24 angeschlossen sind. Durch eine Ansteuerung des Regelverstärkers 11 wird über den Eingang 25 des Verstärkers 5 eine durch die Zeitkonstante entsprechend dem Widerstand 23 und dem Kondensator 24 verzögerte Verstärkungsreduzierung des Verstärkers 5 bewirkt. Das hierdurch zeitlich begrenzte Signal gelangt über das Filter 6, den Demodulator 7 und den Komparator 8 als digitalisiertes Signal auf den Eingang 14 des Mikroprozessors 4 und wird zur Überprüfung der Zeitkonstante gemäß dem Widerstand 23 und dem Kondensator 24 herangezogen.

Bei impulsmäßiger Ansteuerung der Verstärkungssteuerung 12 durch den Ausgang 16 des Mikroprozessors 4 wird ein Steuersignal am Eingang 25 zur Verstärkungsreduzierung des Verstärkers 5 erzeugt, dessen Abklingzeitkonstante vom Widerstand 27 und dem Kondensator 26 bestimmt wird. Durch einen geeigneten zeitlichen Ablauf der Steuersignale am Ausgang 17 und 16 des Mikroprozessors 4 und die Auswertung des Signals an dessen Eingang 14 läßt sich die Zeitkonstante bestehend aus dem Widerstand 27 und dem Kondensator 26 überprüfen.

Der vorangehend beschriebene Prüfablauf kann über die Parametrierschnittstelle 15 aktiviert werden.

Bei der erfindungsgemäßen Lösung wird der standardmäßig vorhandene Mikroprozessor 4 des Näherungsschalters 1, der ansonsten lediglich für die Auswertung dient, zusätzlich für die Erzeugung eines Verstärkereingangssignals, die Ablaufsteuerung und die Auswertung der Ausgangssignale herangezogen. Das Verstärkereingangssignal entsteht durch den entsprechend dimensionierten Spannungsteiler mit den ohmschen Widerständen 18, 19, der durch den Ausgang 17 des Mikroprozessors 4 gespeist wird. Bei zeitlich optimierter Ansteuerung dieses Ausgangs 17 kann der Mikroprozessor 4 durch Abfragen des digitalisierten Verstärkerausgangssignals am Eingang 14 die Funktion des Verstärkers 5, des Demodulators 7 und des Komparators 8 sowie die Zeitkonstanten des Regelverstärkers 11 und der Verstärkungssteuerung 12 überprüfen. In Verbindung mit der bereits vorhandenen Parametrierschnittstelle 15 können sowohl die Einstellparameter für die Prüfung von extern in den Mikroprozessor 4 geladen werden als auch Informationen über die gemessenen Zeitkonstanten und eventuelle Fehlercodes vom Mikroprozessor 4 nach außen übertragen werden.

Die Einspeisung des prozessorgenerierten Rechtecksignals am Eingang 9 anstelle der sonst üblichen sinusförmigen Signale von externen Generatoren ist aufgrund der Signalumformung durch die Filterfunktion, mit der durch einen Tiefpaß Rechteck-Oberwellen entfernt werden, unproblematisch.

Die geeignete Frequenz für das Verstärkereingangssignal am Eingang 9 der Weiterverarbeitungseinheit 3 wird im Mikroprozessor 4 dadurch generiert, daß dessen Quarzfrequenz so gewählt wird, daß die Ausgabe von einem oder mehrerer Taktzyklen des internen Timers die optimale Frequenz ergeben.

Der hochohmige Widerstand 19 des Spannungsteilers zur Einkopplung des Verstärkereingangssignals dient zur Empfindlichkeitseinstellung, da die Wiederverarbeitungseinheit 3 als integrierter Schaltkreis zur Verwendung bei verschiedenen Näherungsschaltertypen realisiert ist. Der niederohmige Widerstand 18 bewirkt eine serielle Einspeisung an dem Verstärkereingang 9, die bei Normalbetrieb des Näherungsschalters 1 keinen störenden Einfluß hat. Das Teilerverhältnis ist so dimensioniert, daß der Ausgangspegel des Mikroprozessors 4 bei einer Mindestempfindlichkeit des Verstärkers 5 zu einer ausreichenden Aussteuerung des Verstärkers 5 führt. Dabei ist es vorteilhaft, daß das Verstärkereingangssignal nicht von außen zugeführt werden muß und sämtliche Messungen bei Bedarf vom Mikroprozessor 4 selbsttätig vorgenommen werden. Dadurch ist in Verbindung mit der bereits vorhandenen Parametrierschnittstelle 15 ein automatisierter "In-Circuit-Test" der kompletten und eventuell bereits vergossenen Näherungsschalter-Sensorik ohne zusätzliche Kontaktiermaßnahmen auch vor Ort in der Anwendung möglich.

Durch die geräteinterne Erzeugung der Prüfsignale werden die ansonsten bei externer Signaleinspeisung üblichen Probleme durch Störeinkopplungen infolge von Masseschleifen, Rauschsignalen usw. vermieden. Die Ausgabe der Prüfwerte und eventueller Fehler sowie die Einstellung der Meß- und Steuerungsparameter kann ohne zusätzlichen Hardwareaufwand über die Parametrierschnittstelle 15 des Näherungsschalter 1 erfolgen.

## Patentansprüche

1. Näherungsschalter (1) mit einem Sensor (2), mit einer diesem über einen Eingang (9) nachgeschalteten Weiterverarbeitungseinheit (3), die zur Verarbeitung eines am Ausgang (13) des Sensors (2) anstehenden Signals dient, und mit einem Mikroprozessor (4) zur Auswertung eines am Ausgang (10) der Weiterverarbeitungseinheit (3) anstehenden Digitalsignals, **dadurch gekennzeichnet,** daß der Mikroprozessor (3) einen Ausgang (17) aufweist, der über ein Netzwerk (18, 19, 20) mit dem Eingang (9) gekoppelt ist, wobei das Netzwerk (18, 19, 20) zur Anpassung und Einkopplung eines im Mikroprozessor (4) generierten Rechtecksignals am Eingang (9) dient.

2. Näherungsschalter nach Anspruch 1, **dadurch gekennzeichnet,** daß das Netzwerk einen ohmschen Spannungsteiler (18, 19) aufweist.

3. Näherungsschalter nach Anspruch 2, **dadurch gekennzeichnet,** daß der Spannungsteiler einen hochohmigen (19) und einen niederohmigen Widerstand (18) aufweist.

4. Näherungsschalter nach einem der vorangehenden Ansprüche, **dadurch gekennzeichnet,** daß die Frequenz des Rechtecksignals aus einem oder mehreren Taktzyklen eines im Mikroprozessor (4) eingebauten Timers gebildet ist.

5. Verfahren zur Funktionsprüfung eines Näherungsschalters (1), der einen Sensor (2), eine Weiterverarbeitungseinheit (3) und einen Mikroprozessor (4) aufweist, wobei die Weiterverarbeitungseinheit (3) zur Verarbeitung eines im Normalbetriebsmodus vom Sensor (2) empfangenen Analogsignals und anschließenden Weiterleitung an den Mikroprozessor (4) zur dortigen Auswertung dient, **dadurch gekennzeichnet,** daß der Mikroprozessor (4) ein Rechtecksignal erzeugt, das einem Netzwerk (18, 19, 20) zugeführt und von diesem als Prüfsignal am Eingang (9) der Weiterverarbeitungseinheit (3) zur deren Funktionsüberprüfung eingekoppelt wird.

6. Verfahren nach Anspruch 4 oder 5, **dadurch gekennzeichnet,** daß die Frequenz des Prüfsignals der Frequenz des vom Sensor (2) im Normalbetriebsmodus an die Weiterverarbeitungseinheit (3) gelieferten Analogsignals entspricht.

7. Verfahren nach einem der Ansprüche 5 oder 6, **dadurch gekennzeichnet,** daß die Einkopplung des Prüfsignals am Eingang (9) der Weiterverarbeitungseinheit (3) über einen Spannungsteiler mit einem hochohmigen Widerstand (19) und einem niederohmigen Widerstand (18) erfolgt, wobei der hochohmige Widerstand zur Amplitudenanpassung des Prüfsignals dient und der niederohmige Widerstand eine serielle Einspeisung am Eingang (9) bewirkt, die bei Normalbetrieb keinen störenden Einfluß hat.
